# EUROPEAN PATENT APPLICATION

(11) **EP 2 523 270 A1**
(43) Date of publication of application: **14.11.2012**
(21) Application number: 12275063.1
(22) Date of filing: 08.05.2012
(51) Int. Cl.: H01R 13/66

(54) **Power monitoring apparatus**

(30) Priority: 09.05.2011 KR 20110043530
(71) Applicant: Samsung Electro-Mechanics Co., Ltd, Suwon, Gyunggi-Do (KR)
(72) Inventor: Yang, Chang Soo, 462-709 Gyeonggi-do (KR); You, Min Su, 443-372 Gyeonggi-do (KR)
(74) Representative: Powell, Timothy John

(57) **Abstract**

Disclosed herein is a power monitoring apparatus (1) supplying power applied to a plug (10) to an electrical device through a socket (20), the power monitoring apparatus including: a detecting unit (30) sensing intensity of current applied to the electrical device to detect an operational state of the electrical device; a power supply unit (40) supplying the power applied to the plug to each component; and a switching unit (50) connected between a connection point between the plug and the socket and the power supply unit and applying the power to the power supply unit or blocking the power applied to the power supply unit according to the operational state of the electrical device.

## Description

### CROSS REFERENCE(S) TO RELATED APPLICATIONS

This application claims the benefit under 35 U.S.C. Section 119 of Korean Patent Application Serial No. 10-2011-0043530, entitled "Power Monitoring Apparatus" filed on May 9, 2011, which is hereby incorporated by reference in its entirety into this application.

### BACKGROUND OF THE INVENTION

### 1. Technical Field

The present invention relates to a power monitoring apparatus, and more particularly, to a power monitoring apparatus capable of measuring power consumption of an electrical device in real time by being connected to the electrical device.

### 2. Description of the Related Art

Recently, products has been developed so as to minimize power consumption in all electrical devices, and various systems and policies have been introduced in order to prevent the national economy loss due to waste of electrical energy by suppressing the unnecessary use of power on a national level.

Particularly, in a situation in which underground resources such as petroleum for producing electricity have been exhausted, practical life of electricity users capable of spontaneously reducing unnecessarily wasted electrical energy as much as possible in each home or office has been urgently demanded.

However, since an apparatus or a system allowing the users to directly confirm power consumption separately in real time in using the electricity in each home, office, or the like, is not currently built, an unnecessarily wasted power amount is not actually recognized.

In order to solve this problem, a power monitoring apparatus having a socket and outlet type external module or a pin and wire type internal module capable of measuring power consumption of an electrical device and providing the measured power consumption to a user has been developed.

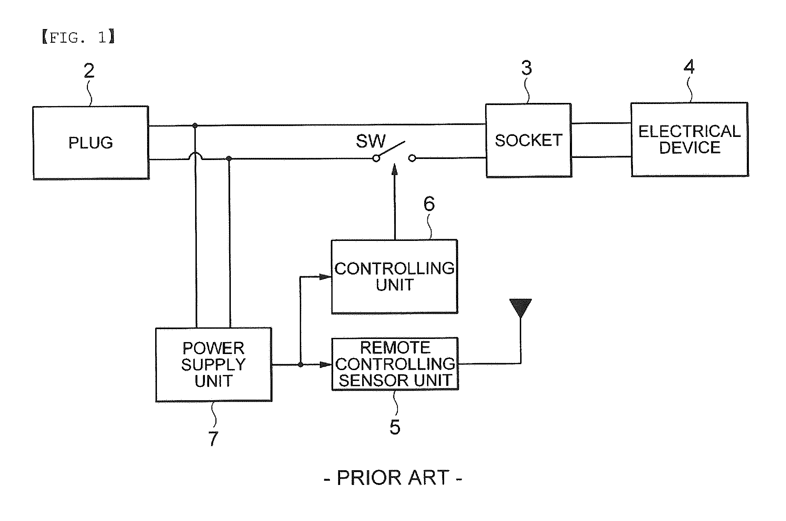

FIG. 1 is a configuration diagram of a general power monitoring apparatus.

As shown in FIG. 1, the general power monitoring apparatus supplies power applied to a plug 2 to an electrical device 4 through a socket 3 and measures power consumption according to the use of the electrical device 4.

In addition, the power monitoring apparatus senses a case in which the electrical device 4 is turned on or a case in which the electrical device 4 is turned off to apply the power to the electrical device 4 or block the power applied to the electrical device 4 in order to reduce standby power generated in the electrical device 4. Further, in order to again operate the electrical device 4, the power monitoring apparatus transmits an operation/stop signal of the electrical device to a remote controller sensor unit 5 through a remote controller to supply the power to the electrical device 4 through the socket 3.

However, since the power monitoring apparatus described above operates the electrical device using the remote controller, it is troublesome to operate the power monitoring apparatus.

Further, in the power monitoring apparatus, since the power is always supplied even in the case in which the electrical device is turned off, the standby power generated in the power monitoring apparatus itself may not be reduced.

As described above, since the standby power is continuously consumed in the power monitoring apparatus, power loss is generated.

### SUMMARY OF THE INVENTION

An object of the present invention is to provide a power monitoring apparatus capable of reducing standby power generated therein by being automatically synchronized according an operational state of an electrical device to control power applied to a power supply unit of the power monitoring apparatus.

According to an exemplary embodiment of the present invention, there is provided a power monitoring apparatus supplying power applied to a plug to an electrical device, the power monitoring apparatus including: a detecting unit sensing intensity of current applied to the electrical device to detect an operational state of the electrical device; a power supply unit supplying the power applied to the plug to each component; and a switching unit connected between a connection point between the plug and the socket and the power supply unit and applying the power to the power supply unit or blocking the power applied to the power supply unit according to the operational state of the electrical device.

The power monitoring apparatus may further include a connecting unit supplying the power applied to the plug to the electrical device.

The connecting unit may have any one of a socket form, an outlet form, a pin form, and a wire form.

The detecting unit may include: a current sensor installed between the plug and the connecting unit to sense the intensity of the current applied to the electrical device; an amplifier amplifying voltage corresponding to the intensity of the current sensed in the current sensor; and outputting a control signal generator comparing the amplified voltage with a preset reference voltage and a control signal controlling an operation of the switching unit according to the comparison result.

The control signal generator may compare the amplified voltage with the preset reference voltage, and output a high control signal for turning on the switching unit when the amplified voltage is the reference voltage or more and output the low control signal for turning off the switching unit when the amplified voltage is less than the reference voltage.

The power supply unit may include: an alternate current (AC)-to-direct current (DC) converter converting AC power applied to the plug into DC power; a battery charged with the converted DC power; and a selector selectively applying the DC power converted in the AC-to-DC converter or the DC power charged in the battery to each component.

The selector may apply the DC power converted in the AC-to-DC converter to each component in a state in which the switching unit is turned on and apply the DC power charged in the battery to the detecting unit in a state in which the switching unit is turned off.

The switching unit may be turned on in a state in which the electrical device is turned on, thereby applying the power applied to the plug to the power supply unit, and may be turned off in a state when the electrical device is turned off, thereby blocking the power applied to the power supply unit.

The state in which the electrical device is turned on may correspond to a case in which a power supply switch provided in the electrical device to supply the power to the electrical device is turned on, and the state in which the electrical device is turned off may correspond to a case in which the power supply switch is turned off.

The power monitoring apparatus may further include a controlling unit measuring intensity of current and a level of voltage applied to the electrical device to measure power consumption of the electrical device.

The power monitoring apparatus may further include a communicating unit providing the measured power consumption of the electrical device to a user through wireless communication.

### BRIEF DESCRIPTION OF THE DRAWINGS

FIG. 1 is a configuration diagram of a general power monitoring apparatus;
FIG. 2 is a configuration diagram of a power monitoring apparatus according to an exemplary embodiment of the present invention; and
FIG. 3 is a perspective view showing an appearance of an external power monitoring apparatus according to an exemplary embodiment of the present invention.

### DESCRIPTION OF THE PREFERRED EMBODIMENTS

Terms and words used in the present specification and claims are not to be construed as a general or dictionary meaning but are to be construed as meaning and concepts meeting the technical ideas of the present invention based on a principle that the inventors can appropriately define the concepts of terms in order to describe their own inventions in best mode.

Therefore, the configurations described in the embodiments and drawings of the present invention are merely most preferable embodiments but do not represent all of the technical spirit of the present invention. Thus, the present invention should be construed as including all the changes, equivalents, and substitutions included in the spirit and scope of the present invention at the time of filing this application.

Hereinafter, exemplary embodiments of the present invention will be described in detail with reference to the accompanying drawings.

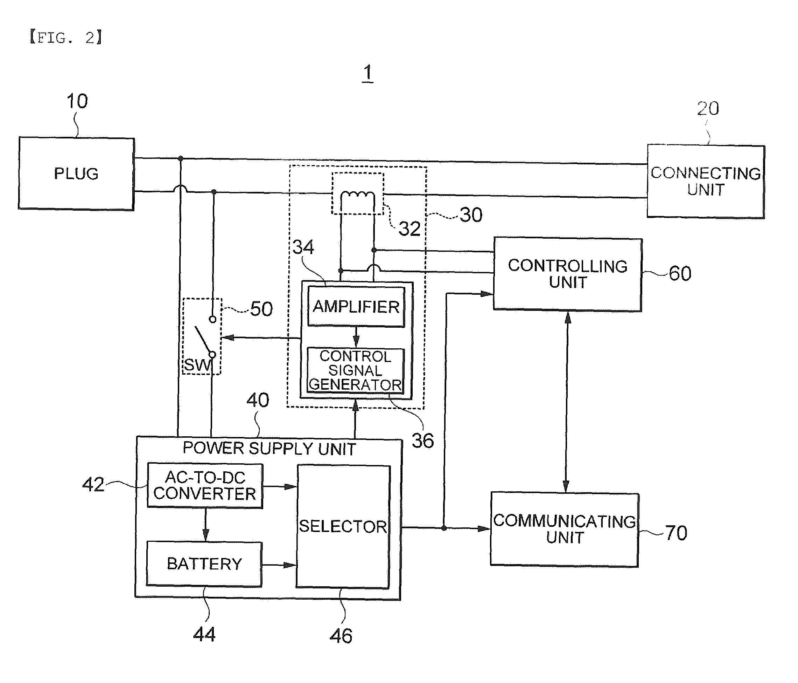

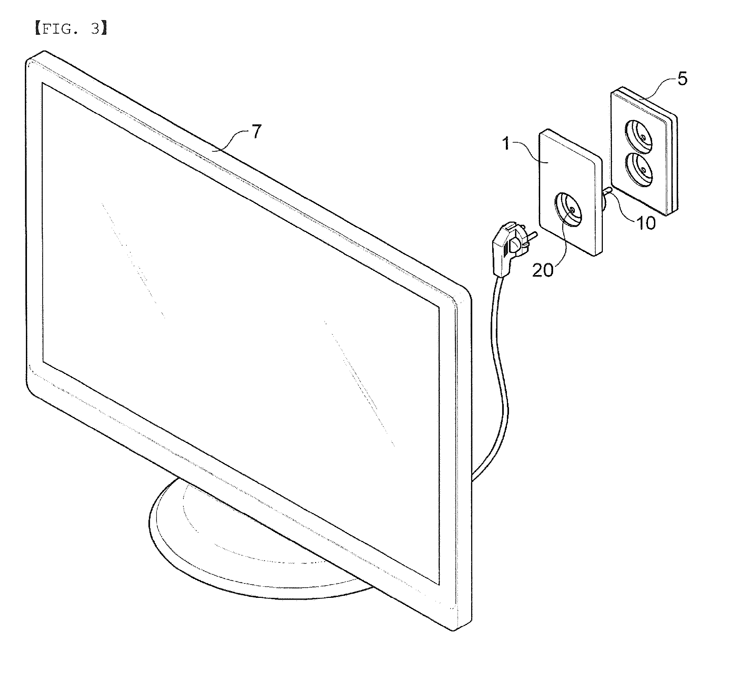

FIG. 2 is a configuration diagram of a power monitoring apparatus according to an exemplary embodiment of the present invention; and FIG. 3 is a perspective view showing an appearance of an external power monitoring apparatus according to an exemplary embodiment of the present invention.

As shown in FIGS. 2 and 3, in the power monitoring apparatus 1, a plug 10 is connected to a main outlet 5 installed on a wall of a home or an office, and an electrical device 7 is connected to a connecting unit 20, such that power is supplied to the electrical device 7.

Although a socket type external module is used as the connecting unit 20 in the exemplary embodiment of the present invention, a pin or wire type internal module may also be used in addition the socket type external module.

This power monitoring apparatus 1 is configured to include a detecting unit 30, a power supply unit 40, a switching unit 50, a controlling unit 60, and a communicating unit 70.

The detecting unit 30, which is a unit detecting an operational state of the electrical device 7 using intensity of current applied to the electrical device 7, includes a current sensor 32, an amplifier 34, and a control signal generator 36.

Among them, the current sensor 32 is installed between the plug 10 and the socket 20 to sense the intensity of the current applied to the electrical device 7. This current sensor 32 may be formed of a current transformer (a CT sensor) sensing intensity of current generated in a coil using magnetic flux density induced by the intensity of the current applied to the electrical device 7.

The amplifier 34 amplifies voltage corresponding to the intensity of the current sensed in the current sensor 32. Since the current sensed in the current sensor 32 as described above has fine intensity, it is difficult to sense a change in current. Therefore, the sensed intensity of the current is converted into voltage and then amplified through the amplifier 34.

The control signal generator 36 compares the voltage amplified in the amplifier 34 with a preset reference voltage and outputs a high control signal or a low control signal according to the comparison result.

More specifically, the control signal generator 36 compares the voltage amplified in the amplifier 34 with the preset reference voltage, judges that the electrical device 7 was turned on to output the high control signal for turning on the switching unit 50 when the voltage amplified in the amplifier 34 is the reference voltage or more, and judges that the electrical device 7 was turned off to output the low control signal for turning off the switching unit 50 when the voltage amplified in the amplifier 34 is less than the reference voltage.

The power supplying unit 40, which is a unit supplying the power applied to the plug 10 to each component (the detecting unit 30, the controlling unit 60, and the communicating unit 70) to operate the power monitoring apparatus 1, includes an alternate current (AC)-to-direct current (DC) converter 42, a battery 44, and a selector 46.

Among them, the AC-to-DC converter 42 is formed of an analog-to-digital converter to convert AC type power applied to the plug 20 into DC type power and then supply the converted DC type power to each component (the detecting unit 30, the controlling unit 60, and the communicating unit 70), such that the power monitoring apparatus 1 is operated.

The battery 44 is a unit charged with the DC power applied from the AC-to-DC converter 42.

In addition, the battery 44 supplies the DC power to the detecting unit 30 in a state in which the switching unit 50 is turned off (that is, a state in which the power monitoring apparatus 1 stops, such that standby power is blocked) to turn on the switching unit 50, such that the power applied to the plug 10 is supplied to the AC-to-DC converter 42, thereby allowing the power monitoring apparatus 1 to be again operated.

The selector 46 applies the DC power converted in the AC-to-DC converter 42 to each component in a state in which the switching unit 50 is turned on, thereby operating the power monitoring apparatus 1, and applies the DC power charged in the battery 44 to the detecting unit 30 in a state in which the switching unit 50 is turned off and the power monitoring apparatus 1 thus stops, thereby allowing the detecting unit 30 to again operate the power monitoring apparatus 1.

As described above, the selector 46 selectively applies one of the DC power converted in the AC-to-DC converter 42 or the DC power charged in the battery 44.

The switching unit 50, which is a unit applying the power to the power supply unit 40 or blocking the power applied to the power supply unit 40 according to an operational state of the electrical device 7 to control an operation of the power monitoring apparatus 1, includes a relay element (SW) connected between a connection point between the plug 10 and the socket 20 and the power supplying unit 40.

More specifically, when the power supply switch provided in the electrical device 7 to supply the power to the electrical device 7 is turned on to turn on the electrical device 7, the intensity of the current sensed in the current sensor 32 increases, such that when the voltage amplified in the amplifier 34 becomes the reference voltage or more, the high control signal is generated. Therefore, the relay element (SW) is turned on in order to activate the power in a standby power state.

In addition, when the electrical device 7 is in use and is then turned off due to turn-off of the power supply switch, the intensity of the current sensed in the current sensor 32 decreases, such that when the voltage amplified in the amplifier 34 becomes less than the reference voltage, the low control signal is generated. Therefore, the relay element (SW) is turned off in order to inactivate the power, thereby reducing standby power generated in the power monitoring device 1 itself.

The controlling unit 60, which is a microcomputer measuring intensity of current and a level of voltage applied to the electrical device 7 to measure power consumption of the electrical device 7, may measure power consumption of the electrical device 7 by the measured intensity of current by the measured level of voltage.

In addition, the controlling unit 60 may also store the measured power consumption of the electrical device 7 therein per predetermined time by including a memory 62 embedded therein.

The communicating unit 70, which is a unit providing the power consumption of the electrical device 7 measured in the controlling unit 60 to a user through wireless communication, transmits the measured power consumption of the electrical device 7 to a terminal or a management server of the user to allow the user to continuously monitor and manage the power consumption of the electrical device 7.

In summary, the power monitoring apparatus 1 according to the exemplary embodiment of the present invention is automatically synchronized according to the operational state of the electrical device 7 to apply the power to the power supply unit 40 in the case in which the electrical device 7 is operated or turned on, thereby operating the power monitoring apparatus 1, and block the power applied to the power supply unit 40 in the case in which the electrical device 7 stops or is turned off, thereby blocking the standby power generated in the power monitoring apparatus 1.

To this end, the battery 44 is embedded in the power supply unit 40, such that even though the power applied to the power supply unit 40 is blocked, the power stored in the battery is supplied to the detecting unit 30 to allow the power to be again supplied to the power supply unit 40, thereby again operating the power monitoring apparatus 1.

As set forth above, the power monitoring apparatus according to the exemplary embodiment of the present invention is automatically synchronized according to the operational state of the electrical device to control the power applied to the power supply unit of the power monitoring apparatus, thereby making it possible to reduce the standby power generated in the power monitoring apparatus.

More specifically, when the power switch in the electrical device is turned off and the power applied to the electrical device is thus reduced, the power applied to the power supply unit of the power monitoring apparatus is blocked, thereby making it possible to reduce the standby power generated in the power monitoring apparatus itself.

In addition, since the power monitoring apparatus is automatically synchronized according to the operational state of the electrical device without using a remote controller, such that the power monitoring apparatus may be controlled, troubles according to an operation of the power monitoring apparatus may be reduced.

Further, the power monitoring apparatus is automatically synchronized according to the operational state of the electrical device without using the remote controller, thereby making it possible to easily measure power consumption of the electrical device.

Although the present invention has been shown and described with the exemplary embodiment as described above, the present invention is not limited to the exemplary embodiment as described above, but may be variously changed and modified by those skilled in the art to which the present invention pertains without departing from the scope of the present invention.

## Claims

1. A power monitoring apparatus supplying power applied to a plug to an electrical device, the power monitoring apparatus comprising:
a detecting unit sensing intensity of current applied to the electrical device to detect an operational state of the electrical device;
a power supply unit supplying the power applied to the plug to each component; and
a switching unit connected between the plug and the power supply unit and applying the power to the power supply unit or blocking the power applied to the power supply unit according to the operational state of the electrical device.

2. The power monitoring apparatus according to claim 1, further comprising a connecting unit supplying the power applied to the plug to the electrical device.

3. The power monitoring apparatus according to claim 2, wherein the connecting unit has any one of a socket form, an outlet form, a pin form, and a wire form.

4. The power monitoring apparatus according to claim 2, wherein the detecting unit includes:
a current sensor installed between the plug and the connecting unit to sense the intensity of the current applied to the electrical device;
an amplifier amplifying voltage corresponding to the intensity of the current sensed in the current sensor; and
a control signal generator comparing the amplified voltage with a preset reference voltage and outputting a control signal controlling an operation of the switching unit according to the comparison result.

5. The power monitoring apparatus according to claim 4, wherein the control signal generator compares the amplified voltage with the preset reference voltage, and outputs a high control signal for turning on the switching unit when the amplified voltage is the reference voltage or more and outputs the low control signal for turning off the switching unit when the amplified voltage is less than the reference voltage.

6. The power monitoring apparatus according to claim 1, wherein the power supply unit includes:
an alternate current (AC)-to-direct current (DC) converter converting AC power applied to the plug into DC power;
a battery charged with the converted DC power; and
a selector selectively applying the DC power converted in the AC-to-DC converter or the DC power charged in the battery to each component.

7. The power monitoring apparatus according to claim 6, wherein the selector applies the DC power converted in the AC-to-DC converter to each component in a state in which the switching unit is turned on and applies the DC power charged in the battery to the detecting unit in a state in which the switching unit is turned off.

8. The power monitoring apparatus according to claim 1, wherein the switching unit is turned on in a state in which the electrical device is turned on, thereby applying the power applied to the plug to the power supply unit, and is turned off in a state the electrical device is turned off, thereby blocking the power applied to the power supply unit.

9. The power monitoring apparatus according to claim 8, wherein the state in which the electrical device is turned on corresponds to a case in which a power supply switch provided in the electrical device to supply the power to the electrical device is turned on, and
the state in which the electrical device is turned off corresponds to a case in which the power supply switch is turned off.

10. The power monitoring apparatus according to claim 1, further comprising a controlling unit measuring intensity of current and a level of voltage applied to the electrical device to measure power consumption of the electrical device.

11. The power monitoring apparatus according to claim 10, further comprising a communicating unit providing the measured power consumption of the electrical device to a user through wireless communication.
